(19) Europäisches Patentamt
European Patent Office
Office européen des brevets

(11) **EP 4 632 440 A1**

(12) **EUROPEAN PATENT APPLICATION**

(43) Date of publication:
**15.10.2025 Bulletin 2025/42**

(21) Application number: **24218597.3**

(22) Date of filing: **10.12.2024**

(51) International Patent Classification (IPC):
*G01V 3/10* (2006.01)    *B60L 53/124* (2019.01)

(52) Cooperative Patent Classification (CPC):
**G01V 3/10; B60L 53/124; H02J 7/0029;**
**H02J 50/10; H02J 50/12; H02J 50/60;** G01V 3/104

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **09.04.2024 US 202463631481 P**
        **06.09.2024 CN 202411247177**

(71) Applicant: **Lite-On Technology Corporation**
**Neihu, Taipei 114 (TW)**

(72) Inventors:
• **LI, Chia-Yuan**
  **114 Taipei (TW)**
• **CHIU, Yu-Wei**
  **114 Taipei (TW)**

(74) Representative: **dompatent von Kreisler Selting**
**Werner -**
**Partnerschaft von Patent- und Rechtsanwälten**
**mbB**
**Deichmannhaus am Dom**
**Bahnhofsvorplatz 1**
**50667 Köln (DE)**

Remarks:
Amended claims in accordance with Rule 137(2)
EPC.

(54) **FOREIGN OBJECT DETECTION DEVICE AND FOREIGN OBJECT DETECTION METHOD THEREOF**

(57)    A foreign object detection device includes a foreign object detection coil, a voltage acquisition module and a controller. The voltage acquisition module is configured to activate a reference voltage acquisition procedure. The reference voltage acquisition procedure includes: when there is no to-be-charged device above the foreign object detection device, a voltage acquisition module obtains a foreign object detection reference voltage of the foreign object detection coil. The controller is configured to: when there is the to-be-charged device above the foreign object detection device, activate a first foreign object detection procedure. The first foreign object detection procedure includes: the controller obtains a coil voltage of the foreign object detection coil; the controller determines whether the coil voltage exceeds a foreign object detection voltage reference value; and, if the coil voltage of the foreign object detection coil exceeds the foreign object detection voltage reference value, the controller starts a protection procedure.

FIG. 1

EP 4 632 440 A1

**Description**

## BACKGROUND OF THE INVENTION

### Field of the Invention

The invention relates in general to a foreign object detection device and a foreign object detection method thereof.

### Description of the Related Art

The principle of wireless charging is based on electromagnetic induction. The alternating current first transmits through a coil in a charging disk (power transmitter) of the FOD (Foreign Object Detection) device to generate magnetic field changes. A coil of a to-be-charged device senses the magnetic field changes and generates an induced current to achieve the charging effect. During the wireless charging process, if there are conductors (herein referred to as "foreign objects") affected by magnetic momentum above the foreign object detection device, such magnetic materials will be improperly heated to a dangerous temperature due to changes in the magnetic field, and thus causes an accident. Therefore, how to detect the presence of foreign objects above the foreign object detection device is one of the goals of industry players in this technical field.

## SUMMARY OF THE INVENTION

According to an embodiment of the present invention, a foreign object detection device is provided. The foreign object detection device includes a foreign object detection coil and a signal acquisition module. The signal acquisition module is electrically connected to the foreign object detection coil and configured to activate a reference voltage acquisition procedure, including: when there is no to-be-charged device above the foreign object detection device, obtain a foreign object detection reference voltage of the foreign object detection coil. The controller electrically connected to the signal acquisition module and configured to: when the to-be-charged device is located above the foreign object detection device, activate a first foreign object detection procedure, including: obtain a coil voltage of one of the foreign object detection coil, determine whether the coil voltage exceeds the foreign object detection reference voltage, and if the coil voltage of the foreign object detection coil exceeds the foreign object detection reference voltage, activate a protection procedure.

According to another embodiment of the present invention, a foreign object detection method of a foreign object detection device includes the following steps: activating a reference voltage acquisition procedure by a signal acquisition module, including: obtaining the foreign object detection reference voltage of the foreign object detection coil when there is no to-be-charged device above the foreign object detection device; activating a first foreign object detection procedure when the to-be-charged device is located above the foreign object detection device, including: obtaining a coil voltage of one of the foreign object detection coil, determining whether the coil voltage exceeds the foreign object detection reference voltage, and if the coil voltage of the foreign object detection coil exceeds the foreign object detection reference voltage, activating a protection procedure.

The above and other aspects of the invention will become better understood with regard to the following detailed description of the preferred but non-limiting embodiment (s). The following description is made with reference to the accompanying drawings.

## BRIEF DESCRIPTION OF THE DRAWINGS

FIG. 1 illustrates a functional block diagram of a foreign object detection device according to an embodiment of the present invention;

FIG. 2 illustrates a schematic diagram of a foreign object detection coil, a first circuit board and a second circuit board;

FIG. 3 illustrates a schematic diagram of a relationship between the foreign object detection coil and its inductance change according to an embodiment of the present invention;

FIG. 4 illustrates a schematic circuit diagram of a resonant capacitor and a foreign object detection coil, a foreign object detection activation circuit and a current detection circuit and a resistor of a sensing unit;

FIG. 5 illustrates a schematic circuit diagram of the foreign object detection activation circuit in FIG. 4;

FIG. 6 illustrates a schematic circuit diagram of a differential voltage detection circuit and a filter circuit of the sensing unit in FIG. 1;

FIG. 7 illustrates a schematic diagram of a relationship between time vs. input voltage of the to-be-charged device according to an embodiment of the present invention; and

FIGS. 8A and 8B illustrate a flow chart of the foreign object detection method of the foreign object detection device in FIG. 1.

## DETAILED DESCRIPTION OF THE INVENTION

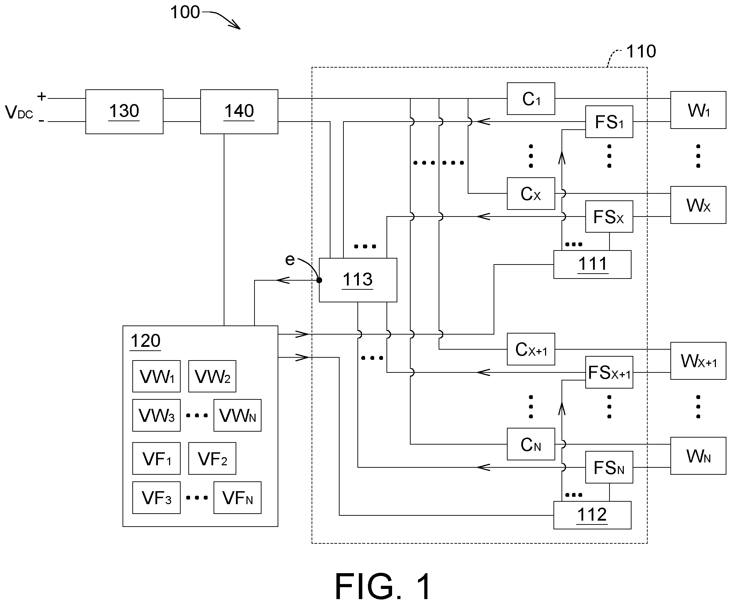

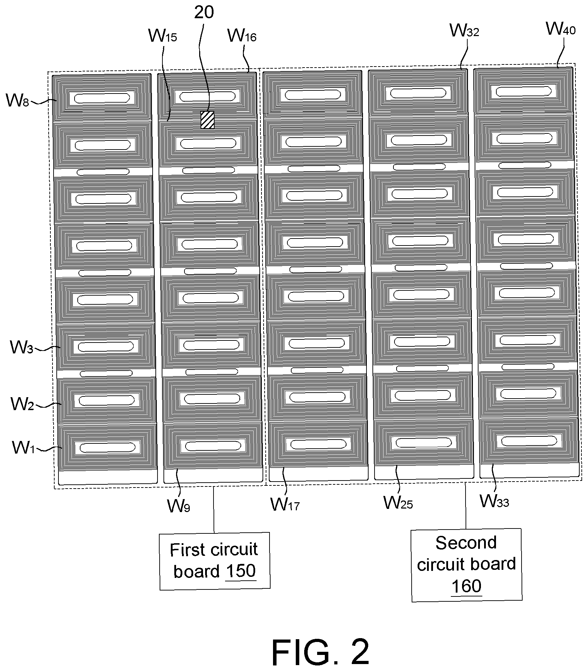

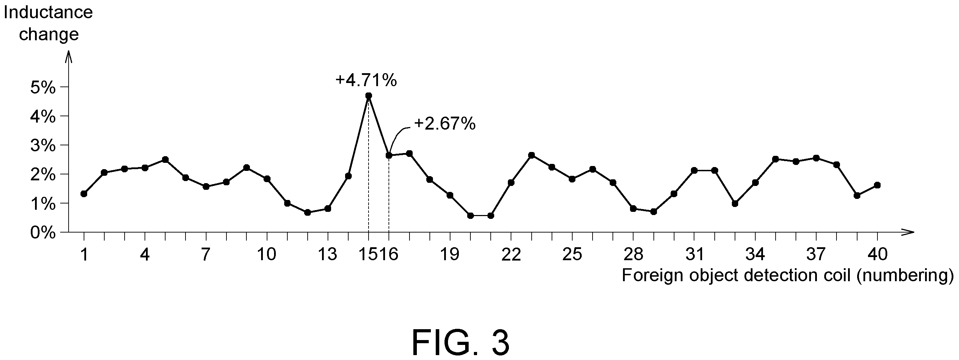

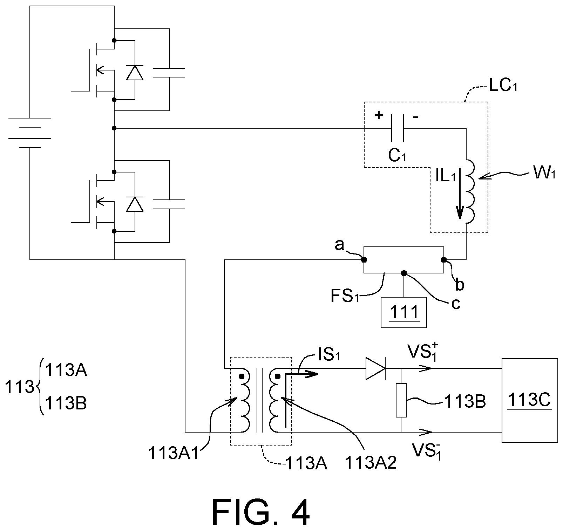

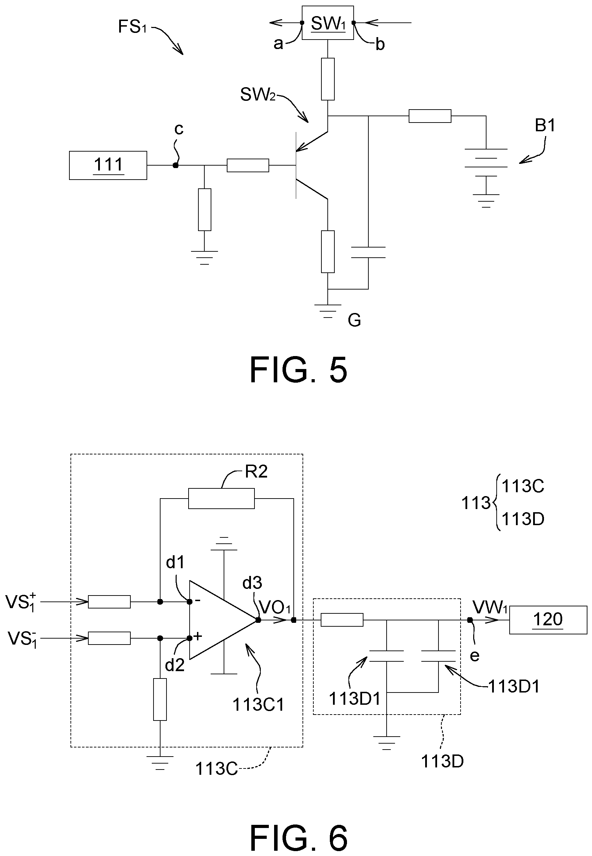

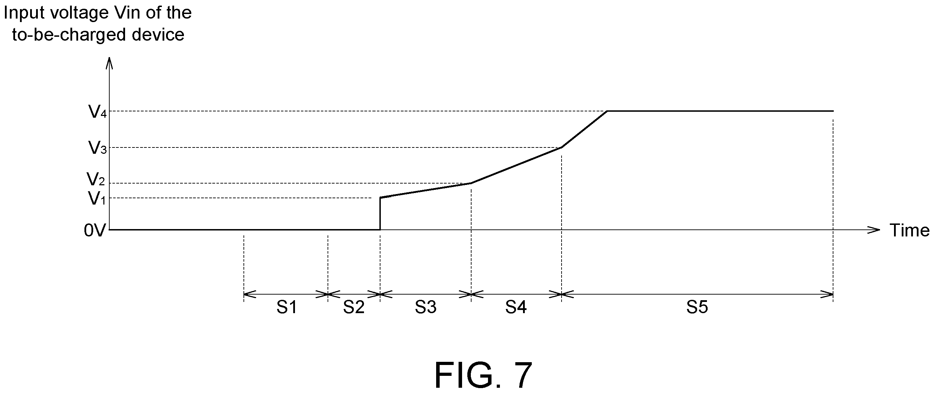

Referring to FIGS. 1 to 7, FIG. 1 illustrates a functional block diagram of a foreign object detection device 100 according to an embodiment of the present invention, FIG. 2 illustrates a schematic diagram of a foreign object detection coil, a first circuit board and a second circuit board, FIG. 3 illustrates a schematic diagram of a relationship between the foreign object detection coil and its inductance change according to an embodiment of the present invention, FIG. 4 illustrates a schematic circuit diagram of a resonant capacitor C1 and a foreign object detection coil $W_1$, a foreign object detection activation circuit $FS_1$ and a current detection circuit 113A and a resistor 113B of a sensing unit 113, FIG. 5 illustrates a schematic circuit diagram of the foreign object detection activation circuit $FS_1$ in FIG. 4, FIG. 6 illustrates a schematic circuit diagram of a differential voltage detection circuit 113C and a filter circuit 113D of the sensing unit 113 in FIG. 1, and FIG. 7 illustrates a schematic diagram of a relationship between time vs. input voltage of the to-be-charged device according to an embodiment of the present invention.

The foreign object detection device 100 is disposed in, for example, a charging management module (not shown) or a server (not shown) controlled by a charging station (not shown). The foreign object detection device 100 may detect whether there is a foreign object disposed under it. The charging station further includes at least one detection device (not shown). The detection device and the foreign object detection device 100 may be disposed in a cloud (not shown) on the internet, and they may communicate with each other through the internet. When the detection device of the charging station detects that the to-be-charged device enters the charging station, the detection device may notify the foreign object detection device 100. The detection device includes, for example, a camera, which may capture images of the to-be-charged device. The charging management module or the server may analyze the image sent by the detection device and recognize an identity of the to-be-charged device. In addition, the to-be-charged device is, for example, a vehicle including at least one wheel, such as an electric car, an electric bus, an electric motorcycle, an electric bicycle, and other various vehicles that may carry goods or living things.

As illustrated in FIGS. 1 and 2, the foreign object detection device 100 includes at least one foreign object detection coil (for example, $W_1$ to $W_N$), a signal acquisition module 110, a controller 120, an electromagnetic interference filter 130, a power amplifier 140, and a first circuit board 150 and a second circuit board 160. The electromagnetic interference filter 130 is electrically connected to a power supply terminal and the power amplifier 140. The power amplifier 140 is electrically connected to the controller 120 and the signal acquisition module 110.

As illustrated in FIGS. 1 and 2, the signal acquisition module 110 is electrically connected to the foreign object detection coils $W_1$ to $W_N$. The signal acquisition module 110 is configured to activate a reference voltage acquisition procedure S1 (the reference voltage acquisition procedure S1 is illustrated in FIG. 7). The reference voltage acquisition procedure S1 includes: when there is no to-be-charged device above the foreign object detection device 100, obtaining the foreign object detection reference voltages VF, to $VF_N$ of the foreign object detection coils $W_1$ to $W_N$. The controller 120 is electrically connected to the signal acquisition module 110 and is configured to: when there is the to-be-charged device above the foreign object detection device 100, activate a first foreign object detection procedure S2 (the first foreign object detection procedure S2 is illustrated in FIG. 7), for example, activate a foreign object detection function of the foreign object detection device 100. The first foreign object detection procedure S2 includes: obtaining the coil voltages $VW_1$ to $VW_N$ of the foreign object detection coils $W_1$ to $W_N$; determining whether the coil voltages $VW_1$ to $VW_N$ exceed the foreign object detection reference voltages VF, to $VF_N$; and, if the coil voltages $VW_1$ to $VW_N$ exceed the foreign object detection reference voltages VF, to $VF_N$ exceed the foreign object detection reference voltages VF, to $VF_N$, activating a protection procedure. For example, the protection procedure includes: the foreign object detection device 100 enters a standby state, and the foreign object detection device 100 starts to operate when a further instruction is received. In the standby state, the foreign object detection device 100 does not perform a charging function, for example. In the present embodiment, the foreign object detection device 100 automatically detects whether there is the foreign object disposed above it, and this it may avoid damage to the foreign object detection device 100 caused by foreign objects.

In an embodiment, the detection device of the charging station may detect whether the to-be-charged device is located above the foreign object detection device 100. When the to-be-charged device is located above the foreign object detection device 100, the detection device may notify the foreign object detection device 100 or notify the foreign object detection device 100 through the charging management module, and the foreign object detection device 100 performs the first foreign object detection procedure S2. In an embodiment, the detection device may use Time of Flight (ToF) radar detection technology to determine whether the to-be-charged device reaches above the foreign object detection device 100. In the first foreign object detection procedure S2, the charging station has not yet charged the to-be-charged device. When the foreign object detection device 100 performs the foreign object detection and confirms that there is no foreign object above the foreign object detection device 100, the charging station starts charging the to-be-charged device.

If the coil voltages $VW_1$ to $VW_N$ of the foreign object detection coils $W_1$ to $W_N$ exceed the foreign object detection reference voltages VF, to $VF_N$, it means that a foreign object may be located on the foreign object detection device 100. If the charging station charges the charging device at this time, it will cause the foreign object detection device 100 is damaged. Due to the foregoing technical solution of the embodiment of the present invention, when the coil voltage exceeds the foreign object detection reference voltage, the controller 120 of the foreign object detection device 100 automatically activates the protection procedure, and/or the controller 120 of the foreign object detection device 100 may output a warning signal (not illustrated) to notify the charging management module, and the charging management module accordingly suspends the charging operation to avoid any possible damage.

The subscript "N" in the foreign object detection coil $W_N$ represents the number of the foreign object detection coils, and "N" may be a positive integer equal to or greater than 1. In the embodiment of the present invention, the value of N is 40 as an example, but it may also be more or less. As illustrated in FIG. 2, the foreign object detection device 100 includes 40 foreign object detection coils $W_1$ to $W_{40}$. In addition, a portion of the foreign object detection coils $W_1$ to $W_N$ (for example, the foreign object detection coils $W_1$ to $W_X$) may be disposed on the first circuit board 150, and the others of the foreign object detection coils $W_1$ to $W_N$ (for example, the foreign object detection coils $W_{X+1}$ to $W_N$) may be disposed on the second circuit board 160. The subscript "X" of the symbol in this article is, for example, a positive integer ranging between 2 to (N-1).

As illustrated in FIG. 1, in an embodiment, in the reference voltage acquisition procedure S1, the signal acquisition module 110 may obtain the foreign object detection reference voltages of the several foreign object detection coils $W_1$ to $W_N$ respectively. For example, the signal acquisition module 110 may obtain the foreign object detection reference voltage $VF_1$ of the foreign object detection coil $W_1$, the foreign object detection reference voltage $VF_2$ of the foreign object detection coil $W_2$, the foreign object detection reference voltage $VF_3$ of the foreign object detection coil $W_3$, ..., and the foreign object detection reference voltage $VF_N$ of the foreign object detection coil $W_N$ is obtained based on such principle. In the first foreign object detection procedure S2, the controller 120 may obtain the individual coil voltage of each of the foreign object detection coils $W_1$ to $W_N$. For example, the signal acquisition module 110 may obtain the coil voltage $VW_1$ of the foreign object detection coil $W_1$, the coil voltage $VW_2$ of the foreign object detection coil $W_2$, the coil voltage $VW_3$ of the foreign object detection coil $W_3$,..., and the coil voltage $VW_N$ of the foreign object detection coil $W_N$ is obtained based on such principle. The controller 120 determines whether the coil voltage exceeds the corresponding foreign object detection reference voltage. For example, the controller 120 determines whether the coil voltage $VW_1$ exceeds the foreign object detection reference voltage $VF_1$, determines whether the coil voltage $VW_2$ exceeds the foreign object detection reference voltage $VF_2$, determines whether the coil voltage $VW_3$ exceeds the foreign object detection reference voltage $VF_3$,..., and de-

termines whether the coil voltage $VW_N$ exceeds the foreign object detection reference voltage $VF_N$ based on this principle. If the coil voltage of any one of these foreign object detection coils is greater than the foreign object detection reference voltage, the protection procedure is activated. For example, if the coil voltage $VW_1$ of the foreign object detection coil $W_1$ exceeds the foreign object detection reference voltage $VF_1$, the protection procedure is activated.

In an embodiment, the controller 120 is further configured to activate the protection procedure when the coil voltage falls outside a normal range. An upper limit value of the normal range is equal to the sum of the foreign object detection reference voltage and an upper limit adjustment value, and a lower limit value of the normal range is equal to a difference between the foreign object detection reference voltage and a lower limit adjustment value. Taking the coil voltage $VW_1$ as an example, when the coil voltage $VW_1$ is outside the normal range, the protection procedure is activated. The upper limit value of the normal range is equal to the sum (that is, $VF_1 + \Delta Va$) of the foreign object detection reference voltage VF, and an upper limit adjustment value $\Delta Va$, and the lower limit value of the normal range is equal to the difference (that is, $VF_1 - \Delta Vb$) between the foreign object detection reference voltage VF, and the lower limit adjustment value $\Delta Vb$. In an embodiment, the upper limit adjustment value $\Delta Va$ is greater than 0, for example, between 0.1 volts and 0.5 volts, and the lower limit adjustment value $\Delta Vb$ is greater than 0, for example, between 0.1 volts and 0.5 volts. However, the embodiment of the present invention does not limit the numerical ranges of the upper limit adjustment value $\Delta Va$ and the lower limit adjustment value $\Delta Vb$.

In an embodiment, the controller 120 is further configured to activate a protection procedure when it is continuously detected that the coil voltage is outside the normal range. The aforementioned "continuous detection" is, for example, 50 times, but it may also be more or less. For example, for each foreign object detection coil, the controller 120 detects the coil voltage every 10 milliseconds (ms). When the coil voltage of any foreign object detection coil is outside the normal range for 50 consecutive times (for example, 0.5 seconds), the controller 120 activates the protection procedure.

As illustrated in FIG. 3, the axis of abscissa represents the numbering of the foreign object detection coil. For example, the numbering 1 represents the foreign object detection coil $W_1$, the numbering 2 represents the foreign object detection coil $W_2$, ... , and so on. When the foreign object 20 (illustrated in FIG. 2) corresponds to a position between the foreign object detection coils $W_{15}$ and $W_{16}$ (corresponding to the numberings 15 and 16 on the x-axis in FIG. 7 respectively), the inductance of the foreign object detection coil $W_{15}$ produces a change of +4.71% (compared to no foreign object 20 being present), and the inductance of the foreign object detection coil $W_{16}$ produces a change of +2.67% (compared to no foreign object 20 being present). It may be seen from this that when the foreign object exists, the inductance of the adjacent foreign object detection coil changes (for example, the inductance increases). In addition, the aforementioned upper limit adjustment value ΔVa and lower limit adjustment value ΔVb may be determined by, for example, the data (experimental or simulation results) illustrated in FIG. 3, but it is not limited by the present invention.

As illustrated in FIG. 1, the foreign object detection reference voltages VF, to $VF_N$ obtained in the reference voltage acquisition procedure S1 may be stored in a memory block (not illustrated). The memory block may be disposed in the controller 120 or in a memory accessible to the controller 120. The subsequent latest foreign object detection reference voltages VF, to $VF_N$ overwrite the contents of this memory block. In an embodiment, the controller 120 is, for example, a microcontroller unit (MCU).

In addition, the reference voltage acquisition procedure S1 may be executed before charging the to-be-charged device. For example, the reference voltage acquisition procedure S1 may be executed when there is no to-be-charged device above the foreign object detection device 100.

In an embodiment, the foreign object detection reference voltage is an average value of multiple coil voltages of the foreign object detection coil. Furthermore, the signal acquisition module 110 is further configured to: in the reference voltage acquisition procedure S1, obtain a number of the coil voltages of each foreign object detection coil, and obtain the average value of these coil voltages, and use the average value as the foreign object detection reference voltage. Taking the foreign object detection coil $W_1$ as a further example, the signal acquisition module 110 may obtain the M coil voltage $VW_1$ of the foreign object detection coil $W_1$, obtain the average value of the M coil voltages of the foreign object detection coil $W_1$, and use this average value as the foreign object detection reference voltage $VF_1$. The other foreign object detection reference voltages $VF_2$ to $VF_N$ are obtained in the same manner as the aforementioned foreign object detection reference voltage VF, and it will not be repeated here. In an embodiment, the value of M is a positive integer equal to or greater than 2, such as 100, smaller, or larger.

As illustrated in FIGS. 1 and 2, the signal acquisition module 110 includes at least one resonant capacitor (for example, $C_1$ to $C_N$), at least one foreign object detection activation circuit (for example, $FS_1$ to $FS_N$), a first multiplexer 111, a second multiplexer 112 and the sensing units 113 (for example, including the current detection circuit 113A and the resistor 113B, as illustrated in FIG. 4, the differential voltage detection circuit 113C and the filter circuit 113D, as illustrated in FIG. 6).

In an embodiment, a portion of the resonant capacitors $C_1$ to $C_N$ (for example, the resonant capacitors $C_1$ to Cx) and the first multiplexer 111 may be disposed on the first circuit board 150 (the first circuit board 150 is illustrated in FIG. 2), and the remaining portion of the resonant capacitors C1 to $C_N$ (for example, the resonant capacitors $C_{X+1}$ to $C_N$) and the second multiplexer 112 may be disposed on the second circuit board 160 (the second circuit board 160 is illustrated in FIG. 2). In addition, the sensing unit 113, the electromagnetic interference filter 130 and/or the power amplifier 140 may be disposed on one of the first circuit board 150 and the second circuit board 160.

As illustrated in FIGS. 1 and 4, the resonant capacitors $C_1$ to $C_N$ are electrically connected to the foreign object detection coils $W_1$ to $W_N$. The resonant capacitors $C_1$ to $C_N$ and the foreign object detection coils $W_1$ to $W_N$ form multiple resonant circuits. For example, the connected resonant capacitor and foreign object detection coil form a resonant circuit. Taking the resonant capacitor $C_1$ as an example, as illustrated in FIG. 4, the resonant capacitor $C_1$ is electrically connected to the foreign object detection coil $W_1$, and the resonant capacitor $C_1$ and the foreign object detection coil $W_1$ form a resonant circuit $LC_1$. Each foreign object detection activation circuit is electrically connected to the corresponding resonant circuit. Taking the foreign object detection activation circuit $FS_1$ as an example, the foreign object detection activation circuit $FS_1$ is electrically connected to the resonant circuit $LC_1$. To avoid overly complicating the diagram, FIG. 4 only illustrates one set of the resonant circuit $LC_1$, and FIG. 5 only illustrates the foreign object detection activation circuit $FS_1$ connected to the resonant circuit $LC_1$.

As illustrated in FIG. 1, the first multiplexer 111 is electrically connected to the foreign object detection activation circuits $FS_1$ to FSx, and the second multiplexer 112 is electrically connected to the foreign object detection activation circuits $FS_{X+1}$ to $FS_N$. To avoid overly complicating the diagram, FIG. 5 only illustrates the first multiplexer 111 connected to the foreign object detection activation circuit $FS_1$ of the plurality of foreign object detection activation circuits. The first multiplexer 111 may turn on (conduct) the foreign object detection activation circuits $FS_1$ to FSx in turn, so that the controller 120 receives the coil voltages $VW_1$ to $VW_X$ in sequence (only the coil voltage $VW_1$ is illustrated in FIG. 6). Similarly, the second multiplexer 112 may turn on the foreign object detection activation circuits $FS_{X+}$, to $FS_N$ in turn, so that the controller 120 may receive the coil voltages $VW_{X+1}$ to $VW_N$ in sequence. In addition, the first multiplexer 111 and the second multiplexer 112 are controlled by the controller 120. The controller 120 may control the first multiplexer 111 and the second multiplexer 112 to turn on the foreign object detection activation circuits $FS_1$ to $FS_N$ in turn.

The foreign object detection activation circuit is electrically connected to the controller 120 and is configured to connect or disconnect the connection between the foreign object detection coil and the controller 120. As illustrated in FIGS. 4 and 5, taking the foreign object

detection activation circuit $FS_1$ as an example, the foreign object detection activation circuit $FS_1$ at least includes a switch $SW_1$. When the switch $SW_1$ is turned on, the connection between the foreign object detection coil $W_1$ and the controller 120 is turned on to activate the detection for the coil voltage; when the switch $SW_1$ is turned off, the connection between the foreign object detection coil $W_1$ and the controller 120 is disconnected to turn off the detection for the coil voltage. In an embodiment, the switch $SW_1$ is, for example, a transistor, such as an N-type metal-oxide-semiconductor field-effect transistor (MOSFET), but it may also be a P-type MOSFET. In addition, the foreign object detection activation circuit $FS_1$ further includes a switch $SW_2$ and a power supply B1. The first multiplexer 111 is electrically connected to an input terminal c of the foreign object detection activation circuit $FS_1$ to control the switch $SW_2$ of the foreign object detection activation circuit $FS_1$ to be turned on or turned off. When the first multiplexer 111 is turned off (for example, controlled by a low level), the switch $SW_2$ is turned on, a gate of the switch $SW_1$ is electrically connected to a ground terminal G, and the switch $SW_1$ is turned off. When the first multiplexer 111 is turned on (for example, controlled by a high level), the switch $SW_2$ is turned off, and the gate of the switch $SW_1$ is electrically connected to the power supply B1. The power supply B1 provides a voltage different from the ground terminal G to the gate of the switch $SW_1$ to turn on the switch $SW_1$. Other foreign object detection activation circuits $FS_2$ to $FS_N$ include the circuit structures similar to or the same as that of the foreign object detection activation circuit $FS_1$, and it will not be repeated here.

In addition, each foreign object detection activation circuit has a turn-on rise time and a turn-off drop time, where the turn-on rise time is the time interval from "a turn-on command sent from the controller 120" to "a capacitor 113D1 of the sensing unit 113 in FIG. 6 reaching a steady-state voltage", and the turn-off drop time is the time interval from "a turn-off command sent from the controller 120" to "the capacitor 113D1 of the sensing unit 113 in FIG. 6 dropping to 0". The conduction time (or patrol time) of each foreign object detection activation circuit is, for example, equal to or greater than the time interval from "the on/off of the switch $SW_1$" to "the capacitor 113D1 reaching the steady state", to avoid obtaining erroneous coil voltage information and causing misjudgment for the foreign matter detection. For example, if the turn-on rise time is 4.5 milliseconds and the turn-off drop time is 4.6 milliseconds, the conduction time of the switch $SW_2$ may be controlled to at least 9.1 milliseconds, such as 10 milliseconds.

When any one of these foreign object detection activation circuits is turned on, the corresponding resonant circuit generates a coil current (or "inductor current"). Taking the foreign object detection activation circuit $FS_1$ as an example, as illustrated in FIG. 4, when the foreign object detection activation circuit $FS_1$ is turned on, the resonant circuit $LC_1$ connected to it generates a coil

current $IL_1$.

As illustrated in FIGS. 4 and 6, after the coil current $IL_1$ transmits through the sensing unit 113, the coil current $IL_1$ may be converted into the coil voltage and output to the controller 120. Taking the coil current $IL_1$ as an example, the coil current $IL_1$ is converted into the coil voltage $VW_1$ after transmitting through the current detection circuit 113A, the resistor 113B, the differential voltage detection circuit 113C and the filter circuit 113D.

Furthermore, as illustrated in FIG. 5, the current detection circuit 113A may induce the coil current $IL_1$ and generate a detection current $IS_1$. The current detection circuit 113A at least includes a primary coil 113A1 and a secondary coil 113A2. When the coil current $IL_1$ transmits through the primary coil 113A1, the secondary coil 113A2 is induced to generate the detection current $IS_1$. In addition, through the design of the windings of the primary coil 113A1 and the windings of the secondary coil 113A2 (a ratio of the number of the winding coils), the ratio of the coil current $IL_1$ to the detection current $IS_1$ may be controlled. For example, if the winding of the primary coil 113A1 and the winding of the secondary coil 113A2 are 1:10, then the value of the detection current $IS_1$ is approximately 1/10 times the coil current $IL_1$, but this ratio is not used to limit the implementation of the present invention.

As illustrated in FIGS. 4 and 5, the resistor 113B is connected to the current detection circuit 113A in parallel. For example, two terminals of the resistor 113B are respectively connected or electrically connected to the two terminals of the secondary coil 113A2 of the current detection circuit 113A. The differential voltage detection circuit 113C is connected with the resistor 113B in parallel. For example, the differential voltage detection circuit 113C at least includes a differential voltage detection comparator 113C1. The differential voltage detection comparator 113C1 includes two input terminals d1 and d2 and an output terminal d3, wherein the two input terminals d1 and d2 are respectively connected to two terminals of the resistor 113B. The differential voltage detection comparator 113C1 may detect a voltage difference between the two terminals of the resistor 113B. When the voltage difference exceeds a preset value, the output terminal d3 outputs an output voltage. The filter circuit 113D is electrically connected to the output terminal d3 of the differential voltage detection circuit 113C. When the output voltage of the differential voltage detection circuit 113C suddenly changes, the capacitor 113D1 of the filter circuit 113D may compensate for the sudden change in the output voltage for reducing the change in the output coil voltage.

Taking the detection current $IS_1$ as an example, after sensing the detection current $IS_1$, the two terminals of the resistor 113B have voltages $VS_1^+$ and $VS_1^-$ respectively, which are respectively input to the differential voltage detection circuit 113C. The two input terminals d1 and d2 of the differential voltage detection comparator 113C1. When the voltage difference between the voltages $VS_1^+$ and $VS_1^-$ exceeds the preset value, the output terminal d3 of the differential voltage detection comparator 113C1 outputs a voltage value $VO_1$. The capacitor 113D1 of the filter circuit 113D may compensate the variation of the output voltage value $VO_1$ (if the variation exceeds the preset value), so as to reduce the variation of the output coil voltage $VW_1$.

In another embodiment, depending on the situation, the sensing unit 113 may omit at least one of the resistor 113B, the differential voltage detection circuit 113C and the filter circuit 113D.

Referring to FIG. 3, FIG. 3 illustrates the relationship between a schematic diagram of the foreign object detection coil and its inductance change according to an embodiment of the present invention. The axis of abscissa represents the numbering of the foreign object detection coil. For example, the numbering 1 represents the foreign object detection coil $W_1$, the numbering 2 represents the foreign object detection coil $W_2$, ... , and so on. When the foreign object 20 (illustrated in FIG. 2) corresponds to the position between the foreign object detection coils $W_{15}$ and $W_{16}$ (corresponding to the numberings 15 and 16 on the x-axis in FIG. 7 respectively), the inductance of the foreign object detection coil $W_{15}$ produces the change of +4.71% (compared to no foreign object 20 being present), and the inductance of the foreign object detection coil $W_{16}$ produces the change of +2.67% (compared to no foreign object 20 being present). It may be seen from this that when the foreign object exists, the inductance of the adjacent foreign object detection coil changes (for example, the inductance increases). In addition, the aforementioned upper limit adjustment value $\Delta Va$ and lower limit adjustment value $\Delta Vb$ may be determined by, for example, the data (experimental or simulation results) illustrated in FIG. 3, but it is not limited by the present invention.

As illustrated in FIG. 7, in an embodiment, the controller 120 is further configured to: when the input voltage $V_{in}$ of the to-be-charged device reaches the first voltage preset value V1, end the first foreign object detection procedure S2 and perform a foreign object detection disabled procedure S3. In the foreign object detection disabled procedure S3, the charging station begins to charge the to-be-charged device, so the input voltage $V_{in}$ continues to rise. The foreign object detection disabled procedure S3 is, for example, turning off the foreign object detection function of the foreign object detection device 100 until the input voltage $V_{in}$ of the to-be-charged device reaches a second voltage preset value V2. The foreign object detection disabled procedure S3 ranges between the first voltage preset value V1 and the second voltage preset value V2. The to-be-charged device includes, for example, an on-board charger (in-vehicle charger), and the input voltage $V_{in}$ is, for example, the input voltage $V_{in}$ (charging voltage) to the on-board charger. The first voltage preset value V1 ranges between, for example, 0 and a nominal working voltage V4. The first voltage preset value V1 is, for example, 406 volts. The nominal working voltage V4 is, for example, 660 volts. The second voltage preset value V2 ranges between, for example, the first voltage preset value V1 and the nominal working voltage V4. The second voltage preset value V2 is, for example, 600 volts. However, the values of the first voltage preset value V1, the second voltage preset value V2 and the nominal working voltage V4 are not limited by the embodiments of the present invention.

In the foreign object detection disabled procedure S3, due to the input voltage $V_{in}$ of the to-be-charged device being in the rising stage, the inductance change of the foreign object detection coil of the foreign object detection device 100 is relatively drastic (even if no foreign object exists), and it may easily lead to the misjudgment for the foreign object detection (if misjudged, it will cause the foreign object detection device 100 to activate the protection procedure and suspend the charging process). Since the foreign object detection device 100 in the embodiment of the present invention turns off the foreign object detection function of the foreign object detection device 100 in the foreign object detection disabled procedure S3, the misjudgment for the foreign object detection may be avoided.

As illustrated in FIG. 7, in an embodiment, the controller 120 is further configured to: when the input voltage $V_{in}$ of the to-be-charged device reaches the second voltage preset value V2, end the foreign object detection disabled procedure S3 and performs a reference voltage update procedure S4 to obtain the latest foreign object detection reference voltage. The reference voltage update procedure S4 ranges between the second voltage preset value V2 and the third voltage preset value V3. The third voltage preset value V3 is, for example, 640V, but this is not intended to limit the embodiment of the present invention. The method of obtaining the update (or the latest) foreign object detection reference voltage is similar or the same as the aforementioned method of obtaining the foreign object detection reference voltage in the reference voltage acquisition procedure S1, and it will not be repeated here. In the reference voltage update procedure S4, the charging station still continues to charge the to-be-charged device, and the foreign object detection function is still turned off.

As illustrated in FIG. 7, after the second voltage preset value V2, the inductance change of the foreign object detection coil of the foreign object detection device 100 has slowed down, and thus the foreign object detection device 100 may re-activate the foreign object detection function. However, before re-activating the foreign object detection function, the foreign object detection device 100 may update the foreign object detection reference voltage to increase the reliability of subsequent foreign object detection.

In an embodiment, the value of the foreign object detection reference voltage obtained in the reference voltage acquisition procedure S1 may be stored in a memory block (not illustrated). The value of the foreign object detection reference voltage obtained in the reference voltage update procedure S4 may cover the same memory block. In the foreign object detection procedure, the controller 120 uses the value of such memory block as the foreign object detection reference voltage.

As illustrated in FIG. 7, in an embodiment, the controller 120 is further configured to: when the input voltage $V_{in}$ of the to-be-charged device reaches the third voltage preset value V3, end the reference voltage update procedure S4 and enter the second foreign object detection procedure S5. For example, the controller 120 again activates the foreign object detection function of the foreign object detection device 100. The second foreign object detection procedure S5 is between the third voltage preset value V3 and the nominal working voltage V4. In the second foreign object detection procedure S5, the controller 120 is further configured to: obtain the coil voltages $VW_1$ to $VW_N$ of the foreign object detection coils $W_1$ to $W_N$; determine whether the coil voltages $VW_1$ to $VW_N$ exceed the latest foreign object detection reference voltages VF, to $VF_N$; and if the coil voltages $VW_1$ to $VW_N$ of the foreign object detection coils $W_1$ to $W_N$ exceed the latest foreign object detection reference voltages VF, to $VF_N$, the protection procedure is activated. For example, the protection procedure includes: the foreign object detection device 100 enters a standby state, and the foreign object detection device 100 just starts to operate when further instruction is received.

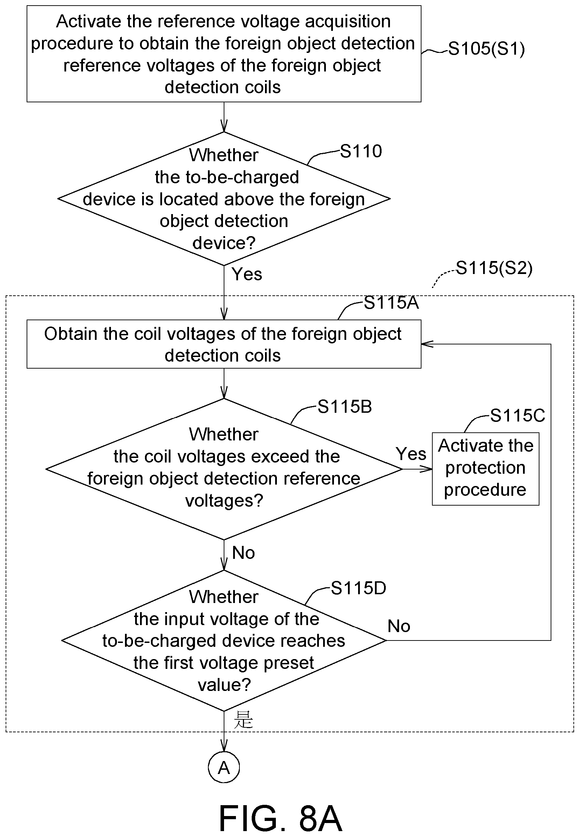

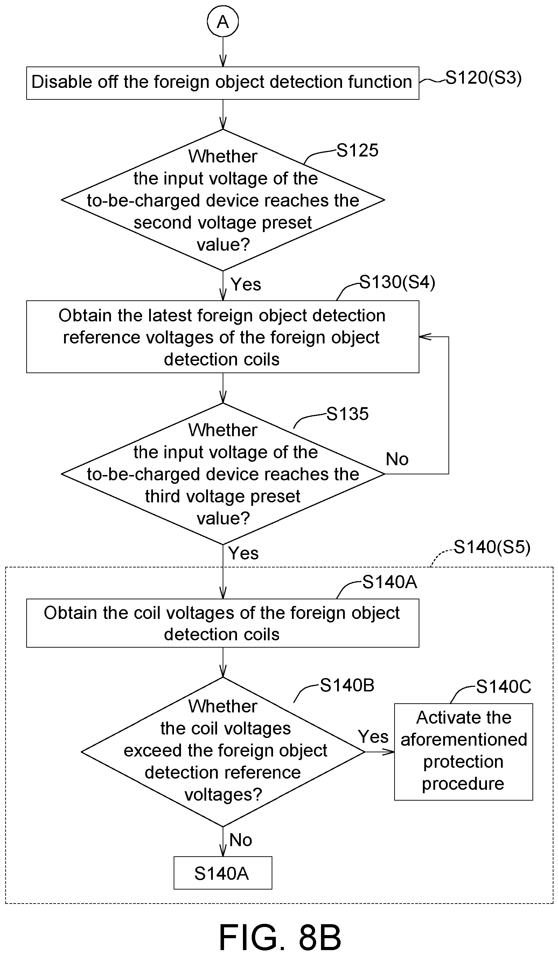

Referring to FIGS. 8A and 8B, FIGS. 8A and 8B illustrate a flow chart of the foreign object detection method of the foreign object detection device 100 in FIG. 1.

In step S105, as illustrated in FIG. 7, the foreign object detection device 100 activates the reference voltage acquisition procedure S1. For example, when there is no to-be-charged device above the foreign object detection device 100, the foreign object detection reference voltages VF, to $VF_N$ of the foreign object detection coils $W_1$ to $W_N$ is obtained by using the aforementioned method. After obtaining the latest foreign object detection reference voltages VF, to $VF_N$, the controller 120 stores the foreign object detection reference voltages VF, to $VF_N$ in the aforementioned memory block, which is disposed in the controller 120, for example.

In step S110, whether the to-be-charged device is located above the foreign object detection device 100 is determined. If the to-be-charged device is located above the foreign object detection device 100, the process proceeds to step S115; if the to-be-charged device is not located above the foreign object detection device 100, the foreign object detection device 100 remains in the standby state.

In step S115, as illustrated in FIG. 7, the controller 120 of the foreign object detection device 100 ends the reference voltage acquisition procedure S1 and activates the first foreign object detection procedure S2. The step S115 may include steps S115A to S115D.

In step S115A, the controller 120 obtains the coil voltages $VW_1$ to $VW_N$ of the foreign object detection coils $W_1$ to $W_N$. For example, as illustrated in FIG. 1, the controller 120 controls the first multiplexer 111 and the second multiplexer 112 to turn on the foreign object detection activation circuits $FS_1$ to $FS_N$ in turn to sequentially obtain the coil voltages $VW_1$ to $VW_N$ of the foreign object detection coils $W_1$ to $W_N$.

In step S115B, the controller 120 determines whether the coil voltages $VW_1$ to $VW_N$ exceed the foreign object detection reference voltages VF, to $VF_N$. In an embodiment, the controller 120 determines whether each of the coil voltages $VW_1$ to $VW_N$ exceeds the corresponding foreign object detection reference voltage. For example, the controller 120 determines whether the coil voltage $VW_1$ exceeds the foreign object detection reference voltage $VW_1$, determines whether the coil voltage $VW_2$ exceeds the foreign object detection reference voltage $VW_2$,..., and so on. If each coil voltage exceeds the corresponding foreign object detection reference voltage, the process proceeds to step S115C; if each coil voltage does not exceed the corresponding foreign object detection reference voltage, the process proceeds to step S115D.

In step S115C, the controller 120 activates the protection procedure.

In step S115D, as illustrated in FIG. 7, the controller 120 determines whether the input voltage Vin of the to-be-charged device reaches the first voltage preset value V1. When the input voltage $V_{in}$ of the to-be-charged device reaches the first voltage preset value V1, the process proceeds to step S120.

In step S120, the controller 120 ends the first foreign object detection procedure S2, activates the foreign object detection disabled procedure S3, and disables the foreign object detection function. In an embodiment, in the foreign object detection disabled procedure S3, the foreign object detection activation circuits $FS_1$ to $FS_N$ may still continue to be turned on in turn, and the controller 120 still continues to receive the coil voltages $VW_1$ to $VW_N$, but the coil voltages $VW_1$ to $VW_N$ are not compared with the foreign object detection activation circuits $FS_1$ to $FS_N$. The reference voltages VF1 to VFN are compared. In the foreign object detection disabled procedure S3, the charging station begins to charge the to-be-charged device, so the input voltage $V_{in}$ continues to rise.

In the foreign object detection disabled procedure S3, as illustrated in FIG. 7, due to the input voltage $V_{in}$ of the to-be-charged device is in an initial rising stage, the inductance variation of the foreign object detection coil of the foreign object detection device 100 is relatively drastic (even if there is no foreign object exists), it is easy to cause misjudgment in foreign object detection (if misjudged, it will cause the foreign object detection device 100 to activate the protection procedure and suspend the charging process). Since the foreign object detection device 100 in the embodiment of the present invention disables the foreign object detection function of the foreign object detection device 100 in the foreign object detection disabled procedure S3, the misjudgment of foreign object detection may be avoided.

In step S125, the controller 120 determines whether the input voltage $V_{in}$ of the to-be-charged device reaches the second voltage preset value V2. When the input voltage $V_{in}$ of the to-be-charged device reaches the second voltage preset value V2, the process proceeds to step S130. When the input voltage $V_{in}$ of the to-be-charged device has not reached the second voltage preset value V2, the process remains in the foreign object detection disabled procedure S3.

In step S130, the controller 120 ends the foreign object detection disabled procedure S3, activates the reference voltage update procedure S4, and obtains the latest foreign object detection reference voltages $VF$, to $VF_N$. After obtaining the latest foreign object detection reference voltages $VF$, to $VF_N$, the controller 120 overwrites the contents of the aforementioned memory block with the latest foreign object detection reference voltages $VF$, to $VF_N$.

In step S135, the controller 120 determines whether the input voltage $V_{in}$ of the to-be-charged device reaches the third voltage preset value V3. When the input voltage $V_{in}$ of the to-be-charged device reaches the third voltage preset value V3, the process proceeds to step S140. The controller 120 ends the reference voltage update procedure S4, activates the second foreign object detection procedure S5, and re-activates the foreign object detection function. When the input voltage $V_{in}$ of the to-be-charged device has not reached the third voltage preset value V3, the process returns to step S130.

The step S140 may include steps S140A to S140C.

In step S140A, the controller 120 obtains the coil voltages $VW_1$ to $VW_N$ of the foreign object detection coils $W_1$ to $W_N$. For example, as illustrated in FIG. 1, the controller 120 controls the first multiplexer 111 and the second multiplexer 112 to turn on the foreign object detection activation circuits $FS_1$ to $FS_N$ in turn to sequentially obtain the coil voltages $VW_1$ to $VW_N$ of the foreign object detection coils $W_1$ to $W_N$.

In step S140B, the controller 120 determines whether the coil voltages $VW_1$ to $VW_N$ exceed the foreign object detection reference voltages $VF$, to $VF_N$. In an embodiment, the controller 120 determines whether each of the coil voltages $VW_1$ to $VW_N$ exceeds the corresponding foreign object detection reference voltage. For example, the controller 120 determines whether the coil voltage $VW_1$ exceeds the latest foreign object detection reference voltage $VW_1$, determines whether the coil voltage $VW_2$ exceeds the latest foreign object detection reference voltage $VW_2$, ..., and so on. If each coil voltage exceeds the corresponding foreign object detection reference voltage, the process proceeds to step S140C; if each coil voltage does not exceed the corresponding foreign object detection reference voltage, the process returns to step S140A.

In step S140C, the controller 120 activates the aforementioned protection procedure.

In summary, embodiments of the present invention provide a foreign object detection device and a foreign object detection method thereof. When the to-be-charged device is not located above the foreign object detection device, the foreign object detection device may automatically obtain the foreign object detection reference voltage of the foreign object detection coil. When the to-be-charged device is located above the foreign object detection device, the foreign object detection device may automatically determine whether there is a foreign object above the foreign object detection device based on the foreign object detection reference voltage. In the foreign object detection procedure, if the coil voltage of the foreign object detection coil is not equal to the foreign object detection reference voltage, or the coil voltage of the foreign object detection coil deviates from a preset range of the foreign object detection reference voltage, the foreign object detection device activates the protection procedure (For example, suspend the charging operation and/or switch to standby mode). In another embodiment, the foreign object detection device may automatically and selectively disable the foreign object detection function or activates (or enable) the foreign object detection function according to the input voltage for the to-be-charged device.

While the invention has been described by way of example and in terms of the preferred embodiment (s), it is to be understood that the invention is not limited thereto. Based on the technical features embodiments of the present invention, a person ordinarily skilled in the art will be able to make various modifications and similar arrangements and procedures without breaching the spirit and scope of protection of the invention. Therefore, the scope of protection of the present invention should be accorded with what is defined in the appended claims.

**Claims**

1. A foreign object detection device (100), **characterized in that** the foreign object detection device (100) comprises:

    a foreign object detection coil ($W_N$);
    a signal acquisition module (110) electrically connected to the foreign object detection coil ($W_N$) and configured to:
    activate a reference voltage acquisition procedure (S1), comprising:
    when there is no to-be-charged device above the foreign object detection device (100), obtain a foreign object detection reference voltage ($VF_N$) of the foreign object detection coil ($W_N$);

and

a controller (120) electrically connected to the signal acquisition module (110) and configured to:

when the to-be-charged device is located above the foreign object detection device (100), activate a first foreign object detection procedure (S2), comprising:

obtain a coil voltage ($VW_N$) of one of the foreign object detection coil ($W_N$);
determine whether the coil voltage ($VW_N$) exceeds the foreign object detection reference voltage ($VF_N$); and
if the coil voltage ($VW_N$) of the foreign object detection coil ($W_N$) exceeds the foreign object detection reference voltage ($VF_N$), activate a protection procedure.

2. The foreign object detection device (100) according to claim 1, **characterized in that** the signal acquisition module (110) is further configured to:

in the reference voltage acquisition procedure (S1), obtain a plurality of the coil voltages ($VW_N$) of the foreign object detection coil ($W_N$); and
in the reference voltage acquisition procedure (S1), obtain an average value of the coil voltages ($VW_N$), and use the average value as the foreign object detection reference voltage ($VF_N$).

3. The foreign object detection device (100) according to claim 1, **characterized in that** the signal acquisition module (110) comprises:

a resonant capacitor ($C_N$) electrically connected to the foreign object detection coil ($W_N$);
wherein the resonant capacitor ($C_N$) and the foreign object detection coil ($W_N$) form a resonant circuit ($LC_1$).

4. The foreign object detection device (100) according to claim 1, **characterized in that** the signal acquisition module (110) comprises:
a foreign object detection activation circuit ($FS_N$) electrically connected to the controller (120) and configured to connect or disconnect a connection between the foreign object detection coil ($W_N$) and the controller (120).

5. The foreign object detection device (100) according to claim 1, **characterized in that** the foreign object detection device (100) comprises a plurality of the foreign object detection coils ($W_N$); the signal acquisition module (110) comprises:

a plurality of foreign object detection activation circuits ($FS_N$) electrically connected to the controller (120), wherein each foreign object detection activation circuit ($FS_N$) is electrically connected to the corresponding foreign object detection coil ($W_N$); and
a multiplexer (111, 112) electrically connected to the foreign object detection activation circuits ($FS_N$), and configured to control the foreign object detection activation circuits ($FS_N$) to be turned on in turn.

6. The foreign object detection device (100) according to claim 1, **characterized in that** the controller (120) is further configured to:

when the coil voltage ($VW_N$) is outside a normal range, activate the protection procedure;
wherein an upper limit value of the normal range is equal to a sum of the foreign object detection reference voltage ($VF_N$) and an upper limit adjustment value ($\Delta Va$), and a lower limit value of the normal range is equal to a difference between the foreign object detection reference voltage ($VF_N$) and a lower limit adjustment value ($\Delta Vb$).

7. The foreign object detection device (100) according to claim 1, **characterized in that** the controller (120) is further configured to:
when an input voltage ($V_{in}$) of the to-be-charged device reaches a first voltage preset value (V1), end the first foreign object detection procedure (S2).

8. The foreign object detection device (100) according to claim 1, **characterized in that** the controller (120) is further configured to:
when an input voltage ($V_{in}$) of the to-be-charged device reaches a second voltage preset value (V2), obtain a latest foreign object detection reference voltage ($VF_N$).

9. The foreign object detection device (100) according to claim 8, **characterized in that** the controller (120) is further configured to:
when an input voltage ($V_{in}$) of the to-be-charged device reaches a third voltage preset value (V3), activate a second foreign object detection procedure (S5), comprising:

obtain the coil voltage ($VW_N$) of the foreign object detection coil ($W_N$);
determine whether the coil voltage ($VW_N$) exceeds the latest foreign object detection reference voltage ($VF_N$); and
if the coil voltage ($VW_N$) of the foreign object detection coil ($W_N$) exceeds the latest foreign object detection reference voltage ($VF_N$), activate the protection procedure.

10. A foreign object detection method of a foreign object detection device (100), **characterized in that** the foreign object detection method comprises:

activating a reference voltage acquisition procedure (S1) by a signal acquisition module (110), comprising:

obtaining the foreign object detection reference voltage $(VF_N)$ of the foreign object detection coil $(W_N)$ when there is no to-be-charged device above the foreign object detection device (100);

activating a first foreign object detection procedure (S2) when the to-be-charged device is located above the foreign object detection device (100), comprising:

obtaining a coil voltage $(VW_N)$ of one of the foreign object detection coil $(W_N)$;

determining whether the coil voltage $(VW_N)$ exceeds the foreign object detection reference voltage $(VF_N)$; and

if the coil voltage $(VW_N)$ of the foreign object detection coil $(W_N)$ exceeds the foreign object detection reference voltage $(VF_N)$, activating a protection procedure.

11. The foreign object detection method according to claim 10, **characterized in that** the foreign object detection method further comprises:

in the reference voltage acquisition procedure (S1), obtaining a plurality of the coil voltages $(VW_N)$ of the foreign object detection coil $(W_N)$; and

in the reference voltage acquisition procedure (S1), obtaining an average value of the coil voltages $(VW_N)$, and using the average value as the foreign object detection reference voltage $(VF_N)$.

12. The foreign object detection method according to claim 10, **characterized in that** the signal acquisition module (110) comprises:

a resonant capacitor $(C_N)$ electrically connected to the foreign object detection coil $(W_N)$;

wherein the resonant capacitor $(C_N)$ and the foreign object detection coil $(W_N)$ form a resonant circuit $(LC_1)$.

13. The foreign object detection method according to claim 10, **characterized in that** the foreign object detection method further comprises:

conducting or disconnecting a connection between the foreign object detection coil $(W_N)$ and the controller (120) by a foreign object detection activation circuit $(FS_N)$.

14. The foreign object detection method according to claim 10, **characterized in that** the signal acquisition module (110) comprises a plurality of foreign object detection activation circuits $(FS_N)$, and the foreign object detection activation circuits $(FS_N)$ are electrically connected to the controller (120); the foreign object detection method comprises:

controlling the foreign object detection activation circuits $(FS_N)$ to be turned on in turn by a multiplexer (111, 112) of the signal acquisition module (110).

15. The foreign object detection method according to claim 10, **characterized in that** the foreign object detection method further comprises:

when the coil voltage $(VW_N)$ is outside a normal range, activating the protection procedure by the controller (120);

wherein an upper limit value of the normal range is equal to a sum of the foreign object detection reference voltage $(VF_N)$ and an upper limit adjustment value $(\Delta Va)$, and a lower limit value of the normal range is equal to a difference between the foreign object detection reference voltage $(VF_N)$ and a lower limit adjustment value $(\Delta Vb)$.

16. The foreign object detection method according to claim 10, **characterized in that** the foreign object detection method further comprises:

when an input voltage $(V_{in})$ of the to-be-charged device reaches a first voltage preset value (V1), ending the first foreign object detection procedure (S2) by the controller.

17. The foreign object detection method according to claim 10, **characterized in that** the foreign object detection method further comprises:

when an input voltage $(V_{in})$ of the to-be-charged device reaches a second voltage preset value (V2), obtaining a latest foreign object detection reference voltage $(VF_N)$ by the controller (120).

18. The foreign object detection method according to claim 17, **characterized in that** the foreign object detection method further comprises:

when an input voltage $(V_{in})$ of the to-be-charged device reaches a third voltage preset value (V3), activating a second foreign object detection procedure (S5) by the controller (120), comprising:

obtaining the coil voltage $(VW_N)$ of the foreign object detection coil $(W_N)$;

determining whether the coil voltage $(VW_N)$ exceeds the latest foreign object detection reference voltage $(VF_N)$; and

if the coil voltage $(VW_N)$ of the foreign object detection coil $(W_N)$ exceeds the latest foreign object detection reference voltage ($VF_N$), activating the protection procedure.

**Amended claims in accordance with Rule 137(2) EPC.**

1. A foreign object detection device (100), **characterized in that** the foreign object detection device (100) comprises:

   a foreign object detection coil ($W_N$);
   a signal acquisition module (110) electrically connected to the foreign object detection coil ($W_N$) and configured to:
   activate a reference voltage acquisition procedure (S1), comprising:
   when there is no to-be-charged device above the foreign object detection device (100), obtain a foreign object detection reference voltage ($VF_N$) of the foreign object detection coil ($W_N$); and
   a controller (120) electrically connected to the signal acquisition module (110) and configured to:
   when the to-be-charged device is located above the foreign object detection device (100), activate a first foreign object detection procedure (S2), comprising:

      obtain a coil voltage ($VW_N$) of the foreign object detection coil ($W_N$);
      determine whether the coil voltage ($VW_N$) is not equal to the foreign object detection reference voltage ($VF_N$); and
      if the coil voltage ($VW_N$) of the foreign object detection coil ($W_N$) is not equal to the foreign object detection reference voltage ($VF_N$), activate a protection procedure;

   wherein the foreign object detection device (100) comprises a plurality of the foreign object detection coils ($W_N$); the signal acquisition module (110) comprises:

      a plurality of foreign object detection activation circuits ($FS_N$) electrically connected to the controller (120), wherein each foreign object detection activation circuit ($FS_N$) is electrically connected to the corresponding foreign object detection coil ($W_N$); and
      a multiplexer (111, 112) electrically connected to the foreign object detection activation circuits ($FS_N$), and configured to control the foreign object detection activation circuits ($FS_N$) to be turned on in turn.

2. The foreign object detection device (100) according to claim 1, **characterized in that** the signal acquisition module (110) is further configured to:

   in the reference voltage acquisition procedure (S1), obtain a plurality of the coil voltages ($VW_N$) of one of the foreign object detection coils ($W_N$); and
   in the reference voltage acquisition procedure (S1), obtain an average value of the coil voltages ($VW_N$), and use the average value as the foreign object detection reference voltage ($VF_N$).

3. The foreign object detection device (100) according to claim 1, **characterized in that** the signal acquisition module (110) comprises:

   a resonant capacitor ($C_N$) electrically connected to the corresponding foreign object detection coil ($W_N$);
   wherein the resonant capacitor ($C_N$) and the corresponding foreign object detection coil ($W_N$) form a resonant circuit ($LC_1$).

4. The foreign object detection device (100) according to claim 1, **characterized in that** the foreign object detection activation circuits ($FS_N$) electrically connected to the controller (120) and each foreign object detection activation circuit ($FS_N$) is configured to connect or disconnect a connection between the corresponding foreign object detection coil ($W_N$) and the controller (120).

5. The foreign object detection device (100) according to claim 1, **characterized in that** the foreign object detection reference voltage ($VF_N$) ranges between an upper limit value and a lower limit value.

6. The foreign object detection device (100) according to claim 1, **characterized in that** the controller (120) is further configured to:
   when an input voltage ($V_{in}$) of the to-be-charged device reaches a first voltage preset value (V1), end the first foreign object detection procedure (S2).

7. The foreign object detection device (100) according to claim 1, **characterized in that** the controller (120) is further configured to:
   when an input voltage ($V_{in}$) of the to-be-charged device reaches a second voltage preset value (V2), obtain a latest foreign object detection reference voltage ($VF_N$).

8. The foreign object detection device (100) according to claim 7, **characterized in that** the controller (120) is further configured to:
   when an input voltage ($V_{in}$) of the to-be-charged device reaches a third voltage preset value (V3), activate a second foreign object detection procedure (S5), comprising:

obtain the coil voltage ($VW_N$) of one of the foreign object detection coils ($W_N$);
determine whether the coil voltage ($VW_N$) is not equal to the latest foreign object detection reference voltage ($VF_N$); and
if the coil voltage ($VW_N$) of the foreign object detection coil ($W_N$) is not equal to the latest foreign object detection reference voltage ($VF_N$), activate the protection procedure.

9. A foreign object detection method of a foreign object detection device (100), **characterized in that** the foreign object detection method comprises:

activating a reference voltage acquisition procedure (S1) by a signal acquisition module (110), comprising:
obtaining the foreign object detection reference voltage ($VF_N$) of a foreign object detection coil ($W_N$) when there is no to-be-charged device above the foreign object detection device (100);
activating a first foreign object detection procedure (S2) when the to-be-charged device is located above the foreign object detection device (100), comprising:

obtaining a coil voltage ($VW_N$) of the foreign object detection coil ($W_N$);
determining whether the coil voltage ($VW_N$) is not equal to the foreign object detection reference voltage ($VF_N$); and
if the coil voltage ($VW_N$) of the foreign object detection coil ($W_N$) is not equal to the foreign object detection reference voltage ($VF_N$), activating a protection procedure;

wherein the signal acquisition module (110) comprises a plurality of foreign object detection activation circuits ($FS_N$), and the foreign object detection activation circuits ($FS_N$) are electrically connected to the controller (120); the foreign object detection method comprises:
controlling the foreign object detection activation circuits ($FS_N$) to be turned on in turn by a multiplexer (111, 112) of the signal acquisition module (110).

10. The foreign object detection method according to claim 9, **characterized in that** the foreign object detection method further comprises:

in the reference voltage acquisition procedure (S1), obtaining a plurality of the coil voltages ($VW_N$) of the foreign object detection coil ($W_N$); and
in the reference voltage acquisition procedure (S1), obtaining an average value of the coil voltages ($VW_N$), and using the average value as the foreign object detection reference voltage ($VF_N$).

11. The foreign object detection method according to claim 9, **characterized in that** the signal acquisition module (110) comprises:

a resonant capacitor ($C_N$) electrically connected to the foreign object detection coil ($W_N$);
wherein the resonant capacitor ($C_N$) and the foreign object detection coil ($W_N$) form a resonant circuit ($LC_1$).

12. The foreign object detection method according to claim 9, **characterized in that** the foreign object detection method further comprises:
conducting or disconnecting a connection between the foreign object detection coil ($W_N$) and the controller (120) by the corresponding foreign object detection activation circuit ($FS_N$).

13. The foreign object detection method according to claim 9, **characterized in that** the foreign object detection reference voltage ($VF_N$) ranges between an upper limit value and a lower limit value.

14. The foreign object detection method according to claim 9, **characterized in that** the foreign object detection method further comprises:
when an input voltage ($V_{in}$) of the to-be-charged device reaches a first voltage preset value (V1), ending the first foreign object detection procedure (S2) by the controller.

15. The foreign object detection method according to claim 9, **characterized in that** the foreign object detection method further comprises:
when an input voltage ($V_{in}$) of the to-be-charged device reaches a second voltage preset value (V2), obtaining a latest foreign object detection reference voltage ($VF_N$) by the controller (120).

16. The foreign object detection method according to claim 15, **characterized in that** the foreign object detection method further comprises:
when an input voltage ($V_{in}$) of the to-be-charged device reaches a third voltage preset value (V3), activating a second foreign object detection procedure (S5) by the controller (120), comprising:

obtaining the coil voltage ($VW_N$) of the foreign object detection coil ($W_N$);
determining whether the coil voltage ($VW_N$) is not equal to the latest foreign object detection reference voltage ($VF_N$); and

if the coil voltage ($VW_N$) of the foreign object detection coil ($W_N$) is not equal to the latest foreign object detection reference voltage ($VF_N$), activating the protection procedure.

FIG. 1

EP 4 632 440 A1

FIG. 2

FIG. 3

FIG. 4

FIG. 5

FIG. 6

Input voltage Vin of the to-be-charged device

FIG. 7

Activate the reference voltage acquisition procedure to obtain the foreign object detection reference voltages of the foreign object detection coils ⌐S105(S1)

Whether the to-be-charged device is located above the foreign object detection device? ⌐S110

Yes

⌐S115(S2)

⌐S115A

Obtain the coil voltages of the foreign object detection coils

Whether the coil voltages exceed the foreign object detection reference voltages? ⌐S115B

Yes → Activate the protection procedure ⌐S115C

No

Whether the input voltage of the to-be-charged device reaches the first voltage preset value? ⌐S115D

No

是

A

# FIG. 8A

A

Disable off the foreign object detection function — S120(S3)

Whether the input voltage of the to-be-charged device reaches the second voltage preset value? — S125

Yes — S130(S4)

Obtain the latest foreign object detection reference voltages of the foreign object detection coils

Whether the input voltage of the to-be-charged device reaches the third voltage preset value? — S135

No

Yes — S140(S5)

Obtain the coil voltages of the foreign object detection coils — S140A

Whether the coil voltages exceed the foreign object detection reference voltages? — S140B

Yes — S140C — Activate the aforementioned protection procedure

No

S140A

FIG. 8B

Europäisches
Patentamt

European
Patent Office

Office européen
des brevets

# EUROPEAN SEARCH REPORT

**Application Number**

EP 24 21 8597

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/212476 A1 (NGUYEN TRONG DUY [US] ET AL) 26 July 2018 (2018-07-26) | 1,2, 6-11, 15-18 | INV.<br>G01V3/10<br>B60L53/124 |
| Y | * figures 1-3,6-11 *<br>* paragraphs [0026] - [0028], [0034] - [0038], [0043] - [0053], [0056] - [0067], [0070], [0074] - [0081], [0088] - [0104] * | 2-5,7-9, 11-14, 16-18 | |
| X | US 2020/161906 A1 (CHOI HYENGCHEUL [KR] ET AL) 21 May 2020 (2020-05-21) | 1,3-6, 10,12-15 | |
| Y | * figures 2-5 *<br>* paragraphs [0033] - [0075], [0081] - [0110] * | 2-5,7-9, 11-14, 16-18 | |
| X | US 2015/323694 A1 (ROY ARUNANSHU MOHAN [US] ET AL) 12 November 2015 (2015-11-12) | 1-6, 8-15,17, 18 | |
| Y | * figures 4A,4B,5-7,10,16,17,24-26 *<br>* paragraphs [0002], [0005], [0025], [0035], [0036], [0183], [0184], [0195] - [0198], [0206], [0221] *<br>* paragraphs [0223] - [0242], [0248] - [0257], [0260] - [0263], [0326] - [0330], [0360] - [0369] *<br>* paragraphs [0380] - [0382], [0384] - [0394] * | 2-5,7-9, 11-14, 16-18 | TECHNICAL FIELDS SEARCHED (IPC)<br><br>G01V<br>H02J<br>B60L |

The present search report has been drawn up for all claims

| Place of search | Date of completion of the search | Examiner |
|---|---|---|
| The Hague | 13 May 2025 | Sartoni, Giovanni |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 8597

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2025

| Patent document cited in search report | Publication date | Patent family member(s) | | Publication date |
|---|---|---|---|---|
| US 2018212476 A1 | 26-07-2018 | NONE | | |
| US 2020161906 A1 | 21-05-2020 | EP | 3654492 A1 | 20-05-2020 |
| | | KR | 20200057550 A | 26-05-2020 |
| | | US | 2020161906 A1 | 21-05-2020 |
| US 2015323694 A1 | 12-11-2015 | CN | 106489082 A | 08-03-2017 |
| | | EP | 3140680 A1 | 15-03-2017 |
| | | JP | 2017518018 A | 29-06-2017 |
| | | US | 2015323694 A1 | 12-11-2015 |
| | | US | 2018329101 A1 | 15-11-2018 |
| | | WO | 2015171910 A1 | 12-11-2015 |

EPO FORM P0459

For more details about this annex : see Official Journal of the European Patent Office, No. 12/82